# EUROPEAN PATENT SPECIFICATION

(11) **EP 3 253 185 B1**
(45) Date of publication and mention of the grant of the patent: **23.02.2022**
(21) Application number: 16172153.5
(22) Date of filing: 31.05.2016
(51) Int. Cl.: H01R 25/16, H02G 3/08, H02G 3/14, H02G 3/16, H05K 1/02, H02G 15/10, H05K 3/36, H01R 25/00, H01R 12/77, H05K 1/11

(54) **ELECTRICAL CONDUCTOR DEVICE, ELECTRICAL WIRING SYSTEM, METHOD FOR PROVIDING AN ELECTRICAL CONDUCTOR DEVICE AND AIRCRAFT**
STROMLEITERVORRICHTUNG, SYSTEM ZUR ELEKTRISCHEN VERDRAHTUNG, VERFAHREN ZUR BEREITSTELLUNG EINER STROMLEITERVORRICHTUNG UND FLUGZEUG
DISPOSITIF CONDUCTEUR ÉLECTRIQUE, SYSTÈME DE CÂBLAGE ÉLECTRIQUE, PROCÉDÉ PERMETTANT DE FOURNIR UN DISPOSITIF CONDUCTEUR ÉLECTRIQUE ET AÉRONEF

(43) Date of publication of application: 06.12.2017
(73) Proprietor: Airbus Operations GmbH, 21129 Hamburg (DE)
(72) Inventor: FREITAG, Klaus-Udo, 21129 Hamburg (DE); PALIT, Yener, 21129 Hamburg (DE)
(74) Representative: Isarpatent

(56) References cited:
- WO-A1-2013/141858
- ES-A1- 2 558 164
- FR-A1- 2 786 653
- JP-A- 2001 060 746
- US-A- 3 701 964
- US-A- 3 950 058
- US-B1- 6 274 819

## Description

### FIELD OF THE INVENTION

The present invention pertains to an electrical conductor device semi-finished product, an electrical wiring system, a method for providing an electrical conductor device, and an aircraft.

Although applicable for any kind of vehicle, the present invention and the corresponding underlying problems will be explained in further detail in conjunction with an aircraft.

### BACKGROUND OF THE INVENTION

Present electrical wiring systems of aircrafts usually comprise a plurality of electrical conductor devices in the form of single cables which are combined in a duct being coupled to a fuselage structure of the aircraft.

US 6 274 819 B1 describes an article comprising a flexible carrier and conductor paths being arranged at the carrier. The conductor paths comprise connection sites that are spaced in equal intervals.

FR 2 786 653 A1 discloses a flexible connection band comprising a flexible layer on which two conductive tracks are formed. The tracks are spaced in a width direction of the band, wherein a distance between the two tracks in the width direction varies. The tracks include connection sites, wherein the band is provided to be cut between adjacent connection sites.

### SUMMARY OF THE INVENTION

It is one of the objects of the invention to provide an electrical conductor device semi-finished product and an electrical wiring system which comprise a light weight structure and which can be installed in an easy and flexible manner, respectively.

At least some of these objects are achieved by the subject-matter of the respective independent claims. Advantageous embodiments are described in the subclaims related to the independent claims.

According to a first aspect of the invention, an electrical conductor device semi-finished product as defined in claim 1 comprises a flexible printed circuit, FPC, comprising a first carrier layer of a flexible dielectric material and extending in a conductor longitudinal direction, and at least one first conductor path of electrically conductive material arranged on a first surface of the first carrier layer and extending along the conductor longitudinal direction, wherein the at least one conductor path comprises a plurality of first connection spots and a plurality of second connection spots, wherein the first and second connecting spots are arranged adjacent to each other with respect to the longitudinal direction. wherein adjacent first and second connecting spots which are arranged at a first distance to each other define a cut-off line between each other which extends cross to the conductor longitudinal direction, and wherein first and second connecting spots which are arranged adjacent each other in a second distance being greater than the first distance define a functional portion between each other. Further, the electrical conductor device comprises a casing layer of a flexible dielectric plastic material embedding the FPC.

In providing the electrical conductor device semi-finished product with the first and second connection spots, a connection interface for connecting the electrical conduction device to further functional components is advantageously formed. In particular, a standardized layout of the FPC may be formed, having a predefined connection interface formed by the first or second connection spots. For example, the FPC may be provided with a particular number of conductor paths, i.e. four paths, each of which comprie first and second connection spots defining a cut-off line between each other. By cutting off the electrical connection device along the cutting-line, the connection interface formed by the first or second connection spots can be exposed and used for electrical connection.

The use of an FPC provides the further advantage, that electronic elements can be advantageously integrated on the carrier layer in-line with the conductor paths. For example surface mounted devices, SMD, can be arranged on the carrier layer and electrically connected to the at least one conductor path. Further, integrated circuits may be arranged on the FPC in order to realize logic circuits on the FPC, or LEDs to provide light effects. Since the FPC is embedded in the casing layer, further protection of the conductor path and for optional SMDs may be obviated. This results in reduced weight of the electrical conductor device.

Further, it is a particular advantage to provide a casing layer of flexible dielectric material embedding the FPC. Thereby, a robust protective structure protecting the FPC is provided. In particular, the casing layer can comprise a fire resistant material.

Furthermore, the casing layer provides functional surfaces for coupling the electrical conductor device to installation structures such as aircraft fuselages, vehicle components or such like. In particular, further cable protective tubes or similar may be omitted due to the casing layer. Therefore, weight of the electrical conductor device is reduced.

As a material for the casing layer, plastic materials may be used. In a particular advantageous embodiment, the casing layer may be formed of a transparent plastic material. This includes the benefit that damages of the conductor paths may be easily determined. In particular, the casing layer may comprise one or more of the following materials: Polyimide, Polyethylene naphthalate (PEN), Polyethylene terephthalate (PET), epoxy, acrylic, phthalic anhydride (PSA).

Since cut-off lines are defined at certain longitudinal intervals, repair and installation of the electrical conductor device is eased.

According to the first aspect of the invention, the FPC comprises at least one second conductor path of electrically conductive material arranged on a second surface of the first carrier layer and extending in the conductor longitudinal direction, wherein the second surface of the first carrier layer is oriented opposite to the first surface, and wherein the at least one second conductor path comprises first connection spots and second connection spots being arranged adjacent to each other with respect to the longitudinal direction and defining a cut-off line between each other.

The second conductor paths may in particular be configured identically and comprise essentially the same properties as the first conductor paths.

In providing conductor paths on the first and the second surface of the carrier layer, very little installation space is needed for the electrical conductor device while maintaining maximum functional flexibility.

Generally, the first and second connection spots in particular may be formed by accumulations of the electrically conductive material forming the at least one first and second conductor path. This offers the possibility to form the section between the connection spots with lower thickness, so that on one hand cutting of along the cut-off lines is faciliated and on the other hand weight is reduced while providing good mechanical stability at the thicker connection spots. Further, the accumulations of electrically conductive material forming the connection spots provide a mechanically robust structure for crimping further electrically functional parts thereto.

As explained above, according to the invention, the at least one first and second conductor paths comprise a plurality of first and second connection spots, wherein one first connection spot and one second connection spot defining one cut-off line between each other are arranged at a first distance to each other, and wherein one further first connection spot is arranged adjacent to the one second connection spot at a second distance being greater than the first distance.

This configuration advantageously provides the possibility to divide the electrical conduction device in several functional units, each of which extending between first and second connection spots. In particular, when damage of the electrical conduction device occurs at a particular location, the functional unit comprising this particular location may be cut-off at the cut-off lines which define the respective functional unit. Then, the conduction paths of a further electrical conduction device may be connected to the exposed connection spots and thus the damaged functional unit can be replaced easily.

In providing first and second connection spots with a short distance therebetween defining a cut-off line and providing first and second connection spots with a long distance therebetween, it is advantageously achieved that the connection spots are located close to the cut-off lines, and hence can be exposed, i.e. by removing the casing layer in this area, easily.

The first distance may in particular measure between 0,1 cm and 5 cm and the second distance may in particular measure between greater than 5 cm and smaller or equal 200 cm. This range for the first distance in particular allows for precise cutting of the electrical conductor device. The above range for the second distance provides an appropriate number of functional units per predefined conductor path length so that a functional unit can be replaced easily in case of damage or failure. According to a second aspect of the invention, an electrical conductor device semi-finished product as defined in claim 2 includes a flexible printed circuit, FPC, comprising a first carrier layer of a flexible dielectric material and extending in a conductor longitudinal direction, and at least one first conductor path of electrically conductive material arranged on a first surface of the first carrier layer and extending along the conductor longitudinal direction, wherein the at least one conductor path comprises a plurality of first connection spots and a plurality second connection spots, wherein the first and second connecting spots are arranged adjacent to each other with respect to the longitudinal direction, wherein adjacent first and second connecting spots which are arranged at a first distance to each other define a cut-off line between each other which extends cross to the conductor longitudinal direction, wherein first and second connecting spots which are arranged adjacent each other in a second distance being greater than the first distance define a functional portion between each other. The electrical conductor device semi-finished product further includes a casing layer of a flexible dielectric plastic material embedding the FPC.

According to this aspect of the invention, the FPC comprises at least two first conductor paths and further comprises a second carrier layer of a flexible dielectric material being connected to the first carrier layer at cross-interconnecting spots of electrically conductive material extending between the first and the second carrier layer. According to this aspect of the invention, in a twist longitudinal section of the FPC a first section of a first conductor path of the at least two first conductor paths extends on the first carrier layer from a first cross-interconnecting spot to a second cross-interconnecting spot and from there a second section of the first conductor path extends on the second carrier layer. Further, a first section of a second conductor path of the at least two first conductor paths extends on the second carrier layer from a third cross-interconnecting spot to a fourth cross-interconnecting spot and from there a second section of the second conductor path extends on the first carrier layer. According to this aspect of the invention, the first and the fourth cross-interconnecting spots are arranged distanced to each other in the conductor longitudinal direction and the second and third cross-interconnecting spots are arranged distanced to each other in the conductor longitudinal direction and distanced to the first and the fourth cross-interconnecting spots in a direction cross to the conductor longitudinal direction. With this configuration, a drilled course of the first and second first conductor paths of the at least two first conductor paths is advantageously realized, thereby providing a possibility to keep influence of disturbing electric or magnetic fields low.

According to one further embodiment, the electrical conductor device semi-finished product may further comprise a shielding including a first and second shielding layer each having a plurality of thin electrically conductive wires, wherein the first and second shielding layers are disposed on opposite sides of the first carrier layer. For example, the first and second shielding layers may be realized as FPCs having a carrier layer with a plurality of very thin conductor paths forming the plurality of wires. Generally, the shielding layer ensures effective shielding of the conductor paths of the FPC of the electrical conductor devices against electric and/or magnetic fields. The first and second shielding layers may in particular be electrically connected to each other. Further, the shielding layers may be electrically connectable to electrical ground potential, for example via one of the at least one first or second conductor paths.

The electrical conductor device semi-finished product further may comprise an adhering coupling layer being disposed on a first surface of the casing layer. The adhering coupling layer allows quick, simple and mechanically reliable installation of the electrical conductor device.

A third aspect of the invention relates to an electrical wiring system as defined in claim 7, comprising an electrical conductor device semi-finished product according to the first or the second aspect of the invention which is cut to a specific length at spaced cut-off lines, a connection box comprising a housing which defines an interior of the box and a lid, and an electrical connection device being arranged in the interior of the box and comprising electrical contact units. The first connection spots of the electrical conductor device semi-finished product are electrically connected to the electrical contact units and an end portion of the electrical conductor device is clamped between the lid and the housing of the connection box.

It is a particular advantage of the electrical wiring system according to the invention that the electrical conductor device semi-finished product is clamped between the lid and the housing of the connection box. Thereby, the electrical conductor device semi-finished product is fixed relative to the box and in particular relative to the electrical contact units being disposed in the interior of the box. This results in an improved protection against mechanical decoupling of the connection spots of the electrical conductor device from the contact units.

Further, the connection box may serve as an adapter device for connecting further electrical functional components thereto. In particular, as will be described in more detail below, a further electrical conduction device may be connected to the connection box. Additionally or alternatively, as further electrical functional components there may be provided an electrical current supply device, an electronic control device or such like.

According to one embodiment, the electrical wiring system may further comprise at least one further electrical conductor device semi-finished product according to one of the before described aspects of the invention which is cut to a specific length at spaced cut-off lines , wherein the first connection spots of the at least one further electrical conductor device are electrically connected to the electrical contact units, and wherein an end portion of the electrical conductor device semi-finished product is clamped between the lid and the housing of the connection box. In this configuration, the connection box serves as an adapter. In particular, junctions or branch-offs can be realized in this way. For example, a main electric conduction device semi-finished product can be connected to the connection box in the afore described manner. Further, a first and a second subordinate electric conduction device each may be connected to the connection box in the same manner. Thereby, the main electric conduction device semi-finished product can be split in two sub arms, which for example may supply electricity to different electrical appliances.

According to a further embodiment, the electrical wiring system may further comprise a strain-relief device including a base part and a clamping part, wherein a section of the electrical conductor device is clamped between the base part and the clamping part of the strain-relief device. Thereby, mechanical pull forces acting along the conductor longitudinal direction may be lowered which provides improved protection against damage of the conductor paths and against undesired deattachment of the first connection spots from the contact units of the connection box.

The strain-relief device may further comprise an adhering coupling layer being disposed on the base part. This allows very simple and quick installation of the strain relief device.

The configuration of the semi-finished product advantageously allows for instance storing the semi-finished product on a storing device, such as a cable roller or such like, and cutting off the electrical conductor device from the electrical conductor device semi-finished product as desired.

According to a fourth aspect of the invention, a method for providing an electrical conductor device as defined in claim 11 is provided. The method comprises providing an electrical conductor device semi-finished product according to the first or the second aspect of the invention, and cutting-off of the electrical conductor device along one of the cut-off lines from the electrical conductor device semi-finished product.

A fifth aspect of the invention concerns an aircraft as defined in claim 12, comprising an electrical conductor device semi-finished according to the first or the second aspect of the invention. In particular, the electrical conductor device semi-finished product described above comprises a low weight per length due to the advantageous integration of the FPC in the casing layer. Further, due to the arrangement of the first and second connection spots of the at least one conductive path of the FPC, the electric conductor device semi-finished product can be cut to a predefined length and subsequently be electrically connected very simple. Hence, installation time and cost can be decreased.

It is of particular advantage that the electrical conductor semi-finished product requires only little installation space due to integration of the FPC into the casing layer. Hence, the electrical conductor device semi-finished product may advantageously be integrated in an aircraft, i.e. as an electrical supply line for electrical functional components arranged within the interior of a fuselage structure of an aircraft, i.e. lighting devices, pumps, or such like. Moreover, the flexible casing layer provides high mechanical reliability at very little weight per length.

In the aircraft, the electrical conduction device semi-finished product may in particular be used for alternating current, AC, supply or direct current, DC, supply to electrical appliances. Voltages may lie for example in the range from 1 Volt to 1000 Volt. Currents may in particular lie in the range from 1 Milliampere to 50 Ampere.

Further, the electrical conductor device semi-finished product may be used in the aircraft for data communication and transfer through the at least one conductor path of the FPC.

In particular, the electrical conductor device may be fixed to a fuselage structure of the aircraft by means of the optional adhering coupling layer. Thereby, very quick, easy, and reliable installation is enabled.

The first and second connecting spots of the conductor paths of the electrical conductor device allow very reliable connection of electric contact components thereto. In particular, the first and second connecting spots allow crimping of electric contact components thereto. This is a great benefit for aircraft wirings since this sort of connection is highly mechanically resistant against decoupling.

Moreover, the aircraft may also comprise the afore described wiring system. In particular, the connection box may be installed to the fuselage structure of the aircraft.

Within the scope of the invention, "fire resistant" or "fire retardant" or "fire proof" may in particular be understood as a property of a respective material, in particular such that the respective materials in case of fire are self-arcing, in particular the respective materials meet the requirements of the UL 94 standard released by Underwriters Laboratories (UL) of the USA.

### BRIEF DESCRIPTION OF THE DRAWINGS

The invention will be explained in greater detail with reference to exemplary embodiments depicted in the drawings as appended.

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.
- Fig. 1: schematically illustrates an exemplary embodiment of an electrical conductor device respective an electrical conductor device semi-finished product not forming part of the invention;
- Fig. 2: shows the embodiment of Fig. 1 in greater detail;
- Fig. 3: schematically illustrates the electrical conductor device according to a further exemplary embodiment not forming part of the invention in a sectional view;
- Fig. 4: schematically illustrates the electrical conductor device according to an exemplary embodiment of the invention in a sectional view;
- Fig. 5: schematically illustrates the electrical conductor device according to a further exemplary embodiment of the invention;
- Fig. 6: schematically illustrates the electrical conductor device according to a further exemplary embodiment of the invention in a sectional view;
- Fig. 7: schematically illustrates an exemplary embodiment of an electrical wiring system according to the invention;
- Fig. 8: schematically illustrates the electrical wiring system according to a further exemplary embodiment of the invention;
- Fig. 9: schematically illustrates the electrical wiring system according to a further exemplary embodiment of the invention;
- Fig. 10: schematically illustrates the interior of a connection box of the electrical wiring system according to an embodiment of the invention;
- Fig. 11: schematically illustrates a lid of a connection box of the electrical wiring system according to an embodiment of the invention;
- Fig. 12: schematically illustrates the electrical wiring system according to a further exemplary embodiment of the invention;
- Fig. 13: schematically illustrates the electrical wiring system according to a further exemplary embodiment of the invention;
- Fig. 14: schematically illustrates an exemplary embodiment of strain-relief device of the electrical wiring system according to a further exemplary embodiment of the invention;
- Fig. 15: schematically illustrates a broken sectional view of an aircraft according to an exemplary embodiment of the invention;
- Fig. 16: schematically illustrates a method for providing an electrical conductor device according to an exemplary embodiment of the invention; and
- Fig.17: schematically illustrates the aircraft as a whole.

In the figures, like reference numerals denote like or functionally like components, unless indicated otherwise. Any directional terminology like "top", "bottom", "left", "right", "above", "below", "horizontal", "vertical", "back", "front", and similar terms are merely used for explanatory purposes and are not intended to delimit the embodiments to the specific arrangements as shown in the drawings.

### DETAILED DESCRIPTION OF THE INVENTION

Although specific embodiments have been illustrated and described herein, it will be appreciated by those of ordinary skill in the art that a variety of alternate and/or equivalent implementations may be substituted for the specific embodiments shown and described without departing from the scope of the present invention. Generally, this application is intended to cover any adaptations or variations of the specific embodiments discussed herein.

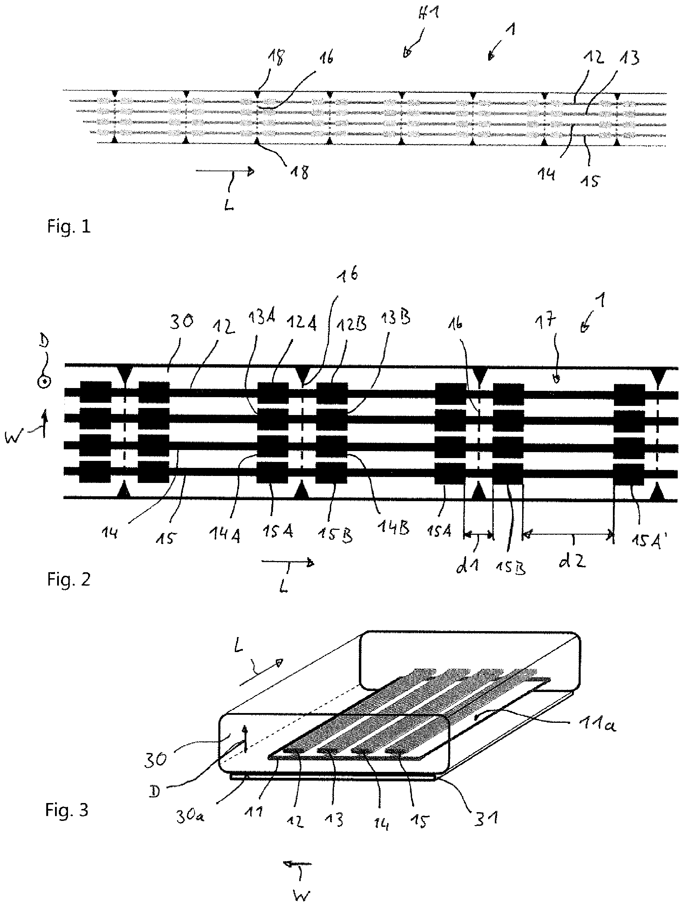

Figs. 1 and 2 show an electrical conductor device 1. Fig. 1 in particular shows an electrical conductor device 1 respective an electrical conductor device semi-finished product H1. The electrical conductor device comprises a flexible printed circuit 10, which is by way of abbreviation referred to as "FPC" in the following, comprising a first carrier layer 11 of a flexible dielectric material. The first carrier layer 11 extends in a conductor longitudinal direction L. The FPC 10 further comprises at least one first conductor path 12, 13, 14, 15 of electrically conductive material arranged on a first surface 11a of the first carrier layer 11. The FPC 10 of the electrical conduction device 1 shown in Figs. 1 to 3 comprises four conductor path 12, 13, 14, 15. However, the number of first conductor paths 12, 13, 14, 15 is not restricted to a particular number. The at least on first conductor path 12, 13, 14, 15 extends along the conductor longitudinal direction L and comprises a first connection spot 12A, 13A, 14A, 15A and a second connection spot 12B, 13B, 14B, 15B. The first and the second connection spot 12A, 13A, 14A, 15A and 12B, 13B, 14B, 15B of the at least one conductor path 12, 13, 14, 15 are arranged adjacent to each other with respect to the longitudinal direction L and define a cut-off line 16 between each other. As shown by way of example in Figs. 1 and 2, the cut-off line 16 extends cross to the conductor longitudinal direction L. The electrical conductor device further comprises a casing layer 30 of a flexible dielectric plastic material embedding the FPC 10.

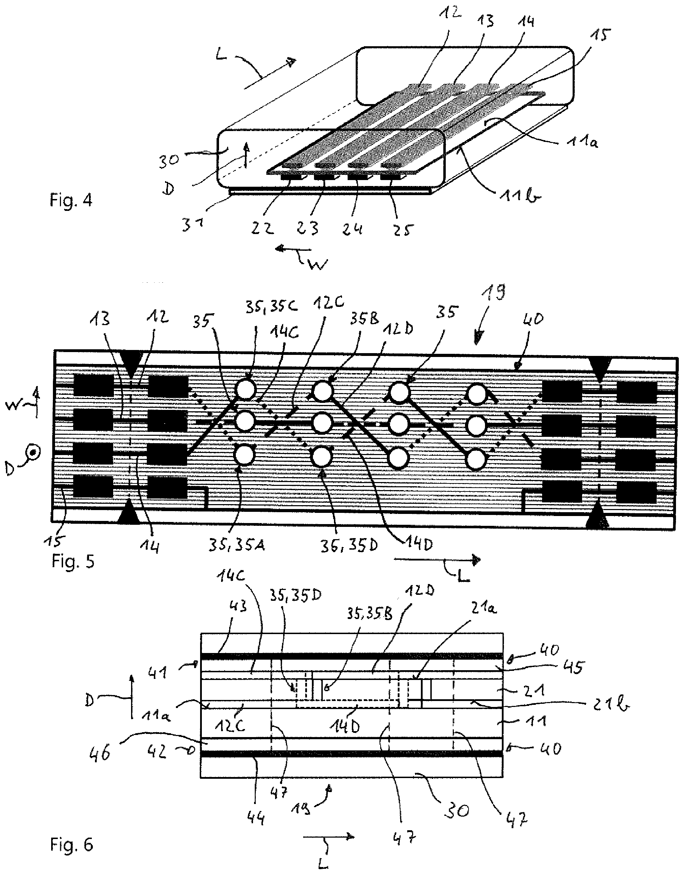

As shown in Fig. 3, the at least one first conductor path 12, 13, 14, 15 is arranged on the first surface 11a of the carrier layer. As shown in Fig. 4, according to one aspect of the invention, the FPC 10 of the electrical conductor device 1 further comprises at least one second conductor path 22, 23, 24, 25 of electrically conductive material arranged on a second surface 11b of the first carrier layer 11 of the FPC. As shown in Fig. 4, the second surface 11b of the carrier layer 11 is oriented opposite to the first surface 11a.

The at least one second conductor path 22, 23, 24, 25 may in particular be formed in an identical manner than the at least one first conductor path 12, 13, 14, 15. Accordingly, any disclosure in the following related to one of the first or second conductor paths is also valid in an analogous manner for the respective other one. In particular, the at least one second conductor path 22, 23, 24, 25 also extends in the conductor longitudinal direction L and comprises first connection spots and second connection spots being arranged adjacent to each other with respect to the longitudinal direction L and defining a cut-off line 16 between each other.

As best can be taken from Fig. 2, the first and second connection spots 12A, 13A, 14A, 15A, 12B, 13B, 14B, 15B may be formed by accumulations of the electrically conductive material forming the at least one first conductor path 12, 13, 14, 15. In particular, the first and second connection spots 12A, 13A, 14A, 15A, 12B, 13B, 14B, 15B in a conductor width direction W, which extends cross to the conductor longitudinal direction L, each may comprise a greater width then the at least one first conductor path 12, 13, 14, 15. Additionally or alternatively, the first and second connection spots 12A, 13A, 14A, 15A, 12B, 13B, 14B, 15B in a conductor depth direction D, which extends cross to the conductor longitudinal direction L and to the conductor width direction W, each may comprise a greater thickness then the at least one first conductor path 12, 13, 14, 15. The first and second connection spots 12A, 13A, 14A, 15A, 12B, 13B, 14B, 15B may for example comprise a rectangular shaped cross-section or a circular shaped cross-section or such like.

The casing layer 30 embeds the FPC 10. In particular, the material forming the casing layer 30 is in contact with the surface the FPC 10. Preferably, the material forming the casing layer 30 and the FPC 10 may adhere to each other. In this case, the first and second contact spots 12A, 13A, 14A, 15A, 12B, 13B, 14B, 15B may comprise a non-bonding surface which avoids adhesion between the first and second contact spots 12A, 13A, 14A, 15A, 12B, 13B, 14B, 15B and the material forming the casing layer 30. This provides the benefit that the casing layer 30 may easily be removed from the first and second contact spots 12A, 13A, 14A, 15A, 12B, 13B, 14B, 15B in order to expose them for contacting.

As shown in particular in Figs. 1 and 2, the at least one first conductor path 12, 13, 14, 15 comprises a plurality of first and second connection spots 12A, 13A, 14A, 15A and 12B, 13B, 14B, 15B. As shown in schematically in Fig. 2 one first connection spot 12A, 13A, 14A, 15A and one second connection spot 12B, 13B, 14B 15B which define one cut-off line 16 between each other are arranged at a first distance d1 to each other, wherein one further first connection spot 12A, 13A, 14A 15A is arranged adjacent to the one second connection spot 12B, 13B, 14B, 15B in a second distance d2 being greater than the first distance d1.

For example, in Fig. 2, along the conductor longitudinal direction L, first connection spot 15A and second connection spot 15B are spaced from each other in the conductor longitudinal direction L by distance d1. Further, first connection spot 15A' is spaced apart from to the second connection spot 15B by distance d2, which is greater than distance d1. First and second connection spots 15A and 15B spaced from each other by distance d1 define a cut-off line 16 between each other. Second connection spot 15B and first connection spot 15A define a functional portion 17 between each other. Hence, generally two adjacent first and second connection spots 12A, 13A, 14A, 15A and 12B, 13B, 14B, 15B being arranged in a first distance d1 along the conductor longitudinal direction L define a cut-off line 16 and second and first connection spots 12B, 13B, 14B, 15B and 12A, 13A, 14A, 15A being arranged at a second distance d2 define a functional portion 17 therebetween, wherein the first distance d1 is greater than the second distance.

Since the casing layer 30 may preferably be formed of a transparent plastic material, cut-off lines 16 may be visually detected, i.e. during maintenance or installation. Additionally or in case that the casing layer 30 is formed of a non-transparent material, markings may be provided on the outer surface of the casing layer 30 as is depicted with reference numeral 18 in Fig. 1 by way of example.

The FPC 10, according to the invention, may also comprise multiple carrier layers 11, 21 as is exemplarily shown in Figs. 5 and 6. As already shown in the examples of Figs. 1 to 5, the FPC, according to the invention, also may comprise multiple conductor paths 12, 13, 14, 15. In Fig. 5, the FPC 10 comprises for example three carrier layers (not shown), in Fig. 6, the FPC 10 comprises two carrier layers 10, 21.

According to one aspect of the invention, the FPC 10 comprises at least two first conductor paths 12, 13, 14, 15 and in particular comprise a second carrier layer 21 in addition to the first carrier layer 21, as shown by way of example in Fig. 6. In particular, the first and second carrier layers 11, 21 are arranged neighboured to each other with respect to the conductor depth direction D, wherein a second surface 21b of the second carrier layer 21 faces the first surface 11a of the first carrier layer 11.

The second carrier layer 21 is also formed of a flexible dielectric material. Further, the second carrier layer 21 may also extend along the conductor longitudinal direction L and further comprises conductor paths on its first surface 21a. Hence, generally, multiple carrier layers 11, 21 may be embedded in one casing layer 30.

According to one aspect of the invention, the second carrier layer 21 is connected to the first carrier layer 11 at cross-interconnecting spots 35. The cross-interconnecting spots 35 are formed of electrically conductive material extending between the first and the second carrier layer 11, 21. As shown exemplary in Fig. 6, the cross-interconnecting spots 35 may be formed as stacks of material forming the first conductor paths 12, 13, 14, 15 and extending along the conductor depth direction D. When the FPC 10 is provided with two carrier layers 11, 21, the FPC 10 comprises at least two first conductor paths 12, 13, 14, 15. In a twist longitudinal section 19 of the FPC 10, a first section 12C of a first conductor path 12 of the at least two first conductor paths 12, 13, 14, 15 extends on the first carrier layer 11 from a first cross-interconnecting spot 35A to a second cross-interconnecting spot 35B. From said second cross-interconnecting spot, a second section 12D of the first conductor path 12 extends on the second carrier layer 21, in particular on the first surface 21a of the second carrier layer 21. Further, a first section 14C of a second conductor path 14 of the at least two first conductor paths 12, 13, 14, 15 extends on the second carrier layer 21, in particular on the first surface 21a of the second carrier layer 21, from a third cross-interconnecting spot 35C to a fourth cross-interconnecting spot 35D. From said fourth cross-interconnecting spot 35D, a second section 14D of the second conductor path 14 extends on the first carrier layer 11. The first and the fourth cross-interconnecting spots 35A, 35D are arranged distanced to each other in the conductor longitudinal direction L and the second and third cross-interconnecting spots 35B, 35C are arranged distanced to each other in the conductor longitudinal direction L. The second and third cross-interconnecting spots 35B, 35C are further distanced to the first and the fourth cross-interconnecting spots 35A, 35D in the conductor width direction W. Accordingly, the first conductor path 12 and the second conductor path 14 of the at least two first conductor paths 12, 13, 14, 15 with respect to the conductor longitudinal direction L extend mutually twisted or winded.

In the example of Fig. 5, the FPC 10 comprises three carrier layers (not shown) and three first conductor paths 12, 13, 14. In Fig. 5, the dotted lines indicate extension of the respective conductor path 12, 13, 14 on a lower most carrier layer with respect to the conductor depth direction D, the dashed lines indicate extension of the respective conductor path 12, 13, 14 on an intermediate carrier layer, and full lines indicate extension of the respective conductor path 12, 13, 14 on an upper most carrier layer with respect to the conductor depth direction D. As can be taken from Fig. 5, the first conductor paths 12, 13, 14 run mutually twisted with respect to the conductor longitudinal direction. A twisted course of the first conductor paths 12, 13, 14, 15 generally has the advantage that disturbing influence of electric or magnetic fields is lowered.

As is shown exemplary in Fig. 5 and 6, the electrical conductor device 1 may comprise a shielding 40 including a first and second shielding layer 41, 42 each having a plurality of thin electrically conductive wires 43, 44. In particular, the shielding layers 43, 44 may be realized as FPCs as well, comprising a shielding carrier layer 45, 46 and a plurality of conductive paths forming the wires 43, 44. The first and second shielding layers 41, 42 are disposed on opposite sides of the first carrier layer 11. In particular, the shielding 40 may surround the first conductor paths 12, 13, 14, 15 and if applicable also the second conductor paths 22, 23, 24, 25 of the FPC 10.

The first and the second shielding layer 43, 44, in particular the wires 43, 44 thereof, may be electrically connected to each other. This may in particular be realized by means of a plurality of shielding connection wires 47 extending in the conductor depth direction D between the first and second shielding layer 43, 44. In order to realize surrounding of the conductor paths 12, 13, 14, 15 and/or conductor paths 22, 23, 24, 25 of the FPC 10, the plurality of shielding connection wires 47 may in particular extend sideward of or between the outermost conductor paths 12, 13, 14, 15 and/or conductor paths 22, 23, 24, 25 of the FPC 10 with respect to the conductor width direction W. Thereby, the FPC 10 as a whole can be surrounded.

Alternatively, in order to realize a surrounding of the FPC 10, the first and second shielding layers 43, 44 may be adhered to each other in their respective side portions, in particular such that the wires 43, 44 of the shielding layers 43, 44 are electrically connected to each other. Furthermore, further shielding layers (not shown) which may be configured identically to shielding layers 43, 44 may be adhered to the first and second shielding layers 43, 44 such that they connect the first and second shielding layers 43, 44 and such that the FPC is surrounded.

The shielding 40 may be connectable to a ground potential via one of the first conductor paths 12, 13, 14, 15 or the second conductor paths 22, 23, 24, 25. In Fig. 5, the shielding 40 is exemplarily shown to be electrically connected to the conductor path 15.

As is shown in Figs. 3 and 4, the electrical conductor device 1 may comprise an adhering coupling layer 31 being disposed on a first surface 30a of the casing layer 30.

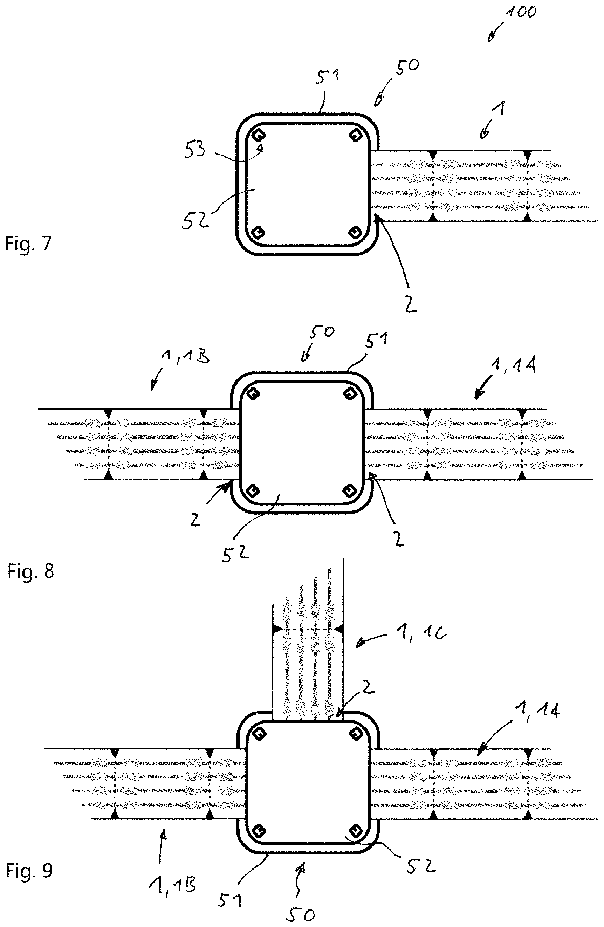

Fig. 7 exemplarily shows an electrical wiring system 100. The electrical wiring system 100 comprises the electrical conductor device 1 and a connection box 50. The connection box 50 comprises a housing 51 which defines an interior I of the connection box 50 and a lid 52. An electrical connection device 60 is arranged in the interior of the box 50 and comprises electrical contact units 61. The electrical contact units 61 may be arranged on a housing carrier plate 62 which is fixed to a bottom of the housing 51 of the contact box. Alternatively, the electrical contact units 61 may be directly mounted to the bottom of the box 51. The contact units 61 may be realized as spring contacts. The contact units 61, to which the contact spots 12A, 13A, 14A, 15A of one electrical conductor device 1 are contacted form a connection port 63, 64, 65, 66.

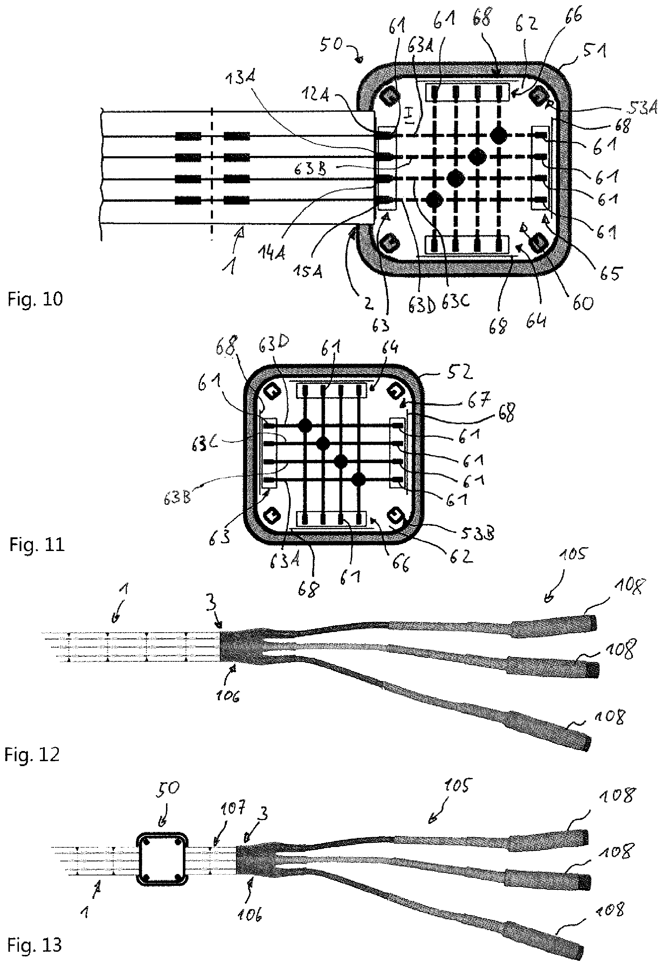

The first connection spots 12A, 13A, 14A, 15A of the electrical conductor device 1 are electrically connected to the electrical contact units 61, as shown schematically in Fig. 10. Further, an end portion 2 of the electrical conductor device 1 is clamped between the lid 52 and the housing 51 of the connection box 50.

The lid 52 may be fixed to the housing 51 by means of a latching mechanism 53. For example, a latching pin 53A may protrude from the housing 51, i.e. from the bottom of the housing 51, which pin being designed to engage with a latching recess 53B of the lid 52. Alternatively, the lid 52 could be screwed or adhesively bonded to the housing 52, for example.

As shown exemplarily and in a schematic manner in Fig. 10, the first contact spots 12A, 13A, 14A, 15A are exposed and electrically contacted to the contact units 61. The contact device 60 comprises a conductor layout with box contact paths 63A, 63B, 63C, 63D which are electrically connected the contact units 61 of one connection port 63, 64, 65, 66. Generally, the number of contact paths corresponds to the number of contact units 61 per connection port 63, 64, 65, 66. The contact paths 63A, 63B, 63C, 63D may electrically connect contact units 61 of one the connection port 63, 64, 65, 66 to contact units 61 of one or more further connection ports 63, 64, 65, 66. For example, in Fig. 10, the contact paths 63A, 63B, 63C, 63D electrically connect the contact units 61 of contact port 63 to the contact units 61 of the contact ports 64, 65 and 66. Alternatively, an electrical power source (not shown) may be arranged in the interior of the housing 50 which is connected to the contact units 61 of a connection port 63, 64, 65, 66.

As exemplarily shown in Figs. 8 and 9, the electrical wiring system 100 may further comprise at least one further electrical conductor device 1. The first connection spots 12A, 13A, 14A, 15A of the at least one further electrical conductor device 1 are electrically connected to the electrical contact units 61, and an end portion 2 of the at least one further electrical conductor device 1 is clamped between the lid 52 and the housing 51 of the connection box 50. For example, in Fig. 8, the electrical conductor device 1A may be connected to the contact units 61 of the contact port 65 and electrical conductor device 1B may be connected to the contact units 61 of the contact port 63. Fig. 9 shows an example with three electrical conductor devices 1A, 1B, 1C, wherein electrical conductor device 1C could be coupled to the contact units 61 of the contact port 64 or 66, for example.

Fig. 11 shows the lid 52 which optionally may comprise alternatively or additional to the contact device 60 a lid contact device 67 which may in particular be configured identically to the contact device 60 described before. If the lid contact device 67 is provided additionally to the contact device 60, the electrical conductor device 1 comprising first conductor paths 12, 13, 14, 15 and second conductor paths 22, 23, 24, 25 may advantageously connected. In particular, the first contact spots of the second conductor paths 22, 23, 24, 25 can be electrically connected to the contact units of the lid conductor device 67 and the first contact spots 12A, 13A, 14A, 15A of the first conductor paths 22, 23, 24, 25 can be electrically connected to the contact units of the conductor device 60.

As is shown further in Figs. 10 and 11, at each of the connection ports 63, 64, 65, 66 a sealing lip 68 may be provided. Thereby, good sealing of the interior I of the box 50 against moisture is achieved.

The layout and manner of connection of the contact paths 63A, 63B, 63C, 63D in Figs. 10 and 11 is only shown in an exemplary and schematic manner an may be configured differently. In particular, the actual course of the contact paths 63A, 63B, 63C, 63D may be altered, for example with respect to the order in which they connect the contact units 61 of the different connection ports 63, 64, 65, 66 to each other.

The connection box 50 may further be provided with an electrical conductive shielding coating (not shown) which may in particular be deposed on surfaces of the housing 51 and the lid 52 facing the interior I of the box 50. In case that the electrical conductor device 1 comprises a shielding 40, said shielding 40 may be electrically connected to the shielding coating 40 of the box 50. Thereby, a so called 360 degree shielding of the box 50 is advantageously achieved.

As shown exemplarily in Fig. 12, an electrical current supply device 105 may be directly connected to the electrical conductor device 1. In particular, electrical supply wires (not shown) of the electrical current supply device 105 may be electrically connected to the first or second contact spots 12A, 13A, 14A, 15A, 12B, 13B, 14B, 15B of the electrical conductor device 1. A sleeve 106 may surround an end portion 3 of the electrical conductor device 1 to which the electrical current supply device 105 is connected.

Alternatively, as exemplarily shown in Fig. 12, the electrical current supply device 105 may comprise a system connection portion 107 which may be identically configured as the electrical conductor device 1. The system connection portion 107 may be connected to the connection box 50 in the manner described above for the electrical conductor device 1. Such a configuration of the electrical wiring system 100 allows maximum flexibility with regard to connection of a plurality of different electrical appliances via the electrical current supply device 105.

The electrical current supply device 105 may comprise appliance connection portions 108 which may in particular be realized as jiffy junctions, pins, sockets or such like.

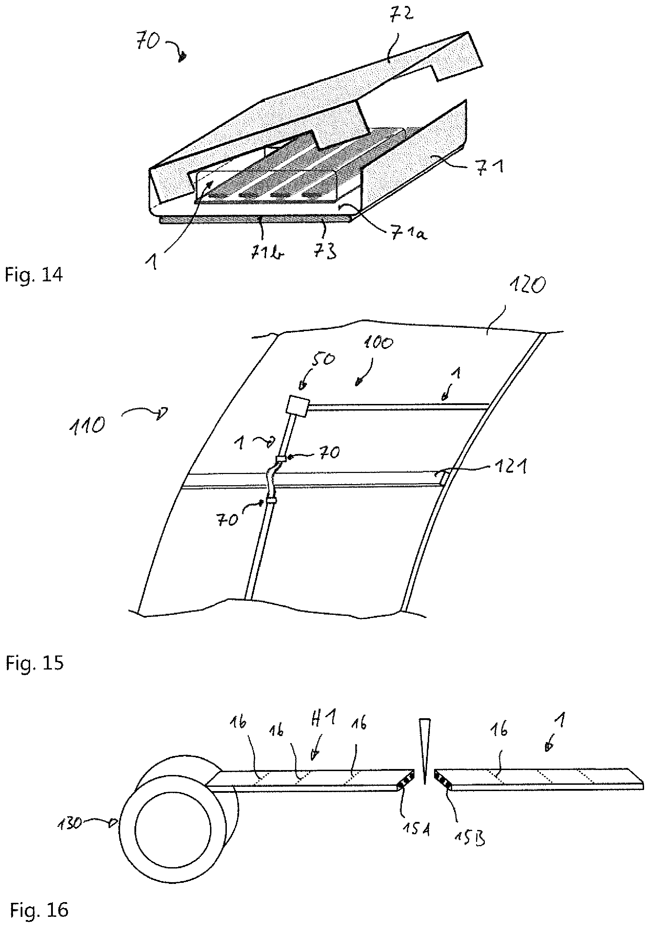

The electrical wiring system 100 may further comprise a strain-relief device 70. As shown schematically in Fig. 14, the strain-relief device includes a base part 71 and a clamping part 72, wherein a section of the electrical conductor device 1 is clamped between the base part 71 and the clamping part 72 of the strain-relief device 70. In particular, the electrical conductor device 1 is clamped between an upper surface 71a of the base part 71 and the clamping part 71. The clamping part 72 may for example be pivotally coupled to the base part 71. Generally, the clamping part 72 may be releasably fixed to the base part 71. This can be realized for example by means of a latching device (not shown), by means of screwing of the clamping part 72 to the base part 71, or in similar fashion.

As further shown in Fig. 14, the strain-relief device 70 may comprise an adhering coupling layer 73 being disposed on the base part 71, in particular on a lower surface 71b of the base part 71, wherein the lower surface 71b lies opposite to the upper surface 71a of the base part.

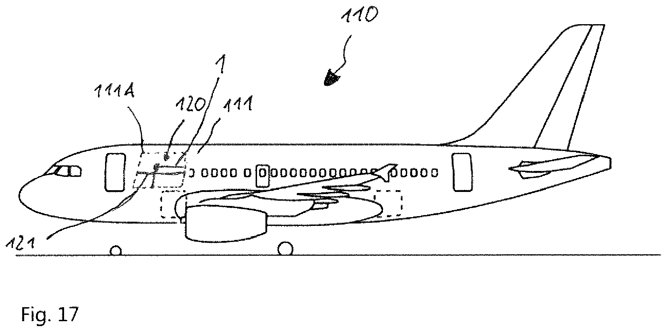

Fig. 17 schematically illustrates an aircraft 110 comprising the electrical conductor device 1. In Fig. 17 an outer skin 111 of the aircraft is shown interrupted in the area depicted by reference number 111A in order to show a fuselage structure 120 located underneath the outer skin 111. Fig. 15 schematically shows a section of the aircraft in which the electrical conductor device 1 may in particular be located. As shown, the electrical conductor device 1 may be fixed to the fuselage structure 120 of the aircraft. In particular, the electrical conductor device 1 may be fixed to the fuselage structure 120 by means of the adhering coupling layer 31. The fuselage structure 120 for example may be a cabin monument such as a lavatory or a galley.

As is further shown exemplary in Fig. 15, the aircraft may also comprise the electrical wiring system. The electrical conductor device 1 may be connected to connection box 50, in particular in the afore described fashion. The connection box 50, and the optional strain-relief device 70 may also be installed to the fuselage structure 120 of the aircraft. As Fig. 15 shows, the strain-relief device 70 is preferably arranged in an area where the electrical conductor device 1 crosses obstacles, such as rib 121 or the like. In such areas, the electrical conductor device 1 preferably is installed so as to form an arch.

As already mentioned before, the electrical conductor device 1 is provided as an electrical conductor device semi-finished product H1. The electrical conductor device semi-finished product H1 comprises the FPC 10 having the first carrier layer 11, and the at least one first conductor path 12, 13, 14, 15 which comprises a plurality of first connection spots 12A, 13A, 14A, 15A and a plurality of second connection spots 12B, 13B, 14B, 15B. The first and second connecting spots 12A, 13A, 14A, 15A and 12B, 13B, 14B, 15B are arranged adjacent to each other with respect to the longitudinal direction L defining a cut-off line 16 between each other, respectively. The electrical conductor device semi-finished product H1 further comprises the casing layer 30 of a flexible dielectric plastic material embedding the FPC 10. Accordingly, the electrical conductor device semi-finished product H1 comprises a plurality of electrical conductor devices 1.

The electrical conductor device semi-finished product H1 may be stored on a storing device, such as cable roller 130, for example, as schematically shown in Fig. 16.

A method for providing an electrical conductor device 1 comprises providing the electrical conductor device semi-finished product H1, for example on a cable roller 130, as shown in Fig. 16. The method further comprises cutting-off of the electrical conductor device 1 along one of the cut-off lines 16 from the electrical conductor device semi-finished product H1. This step can be carried out using a cutting device 135, as is schematically shown in Fig. 16.

In the foregoing detailed description, various features are grouped together in one or more examples or examples with the purpose of streamlining the disclosure. It is to be understood that the above description is intended to be illustrative, and not restrictive. Many other examples will be apparent to one skilled in the art upon reviewing the above specification.

The embodiments were chosen and described in order to best explain the principles of the invention and its practical applications, to thereby enable others skilled in the art to best utilize the invention and various embodiments with various modifications as are suited to the particular use contemplated. In the appended claims and throughout the specification, the terms "including" and "in which" are used as the plain-English equivalents of the respective terms "comprising" and "wherein," respectively. Furthermore, "a" or "one" does not exclude a plurality in the present case.

### List of reference signs

- 1: electrical conductor device
- 2: end portion of the electrical conductor device
- 3: end portion of the electrical conductor device
- 5: electrical conductor device semi-finished product
- 10: flexible printed circuit
- 11: first carrier layer
- 11a: first surface of the first carrier layer
- 11b: second surface of the first carrier layer
- 12: first conductor path
- 13: first conductor path
- 14: first conductor path
- 15: first conductor path
- 12A: first connection spot
- 13A: first connection spot
- 14A: first connection spot
- 15A: first connection spot
- 12B: second connection spot
- 13B: second connection spot
- 14B: second connection spot
- 15B: second connection spot
- 12C: first section of a first conductor path of at least two first conductor paths
- 12D: second section of the first conductor path of the at least two first conductor paths
- 14C: first section a second conductor path of the at least two first conductor paths
- 14D: second section the second conductor path of the at least two first conductor paths
- 16: cut-off line
- 17: functional portion
- 18: markings
- 19: twist longitudinal section
- 22: second conductor path
- 23: second conductor path
- 24: second conductor path
- 25: second conductor path
- 30: casing layer
- 31: adhering coupling layer of the electrical conductor device
- 35: cross-interconnecting spots
- 35A: first cross-interconnecting spot
- 35B: second cross-interconnecting spot
- 35C: third cross-interconnecting spot
- 35D: fourth cross-interconnecting spot
- 40: shielding
- 41: first shielding layer
- 42: second shielding layer
- 43; 44: wires
- 45; 46: shielding carrier layer
- 47: shielding connection wires
- 50: connection box
- 51: housing
- 52: lid
- 53: latching mechanism
- 53A: latching pin
- 53B: latching recess
- 60: electrical connection device
- 61: electrical contact units
- 62: housing carrier plate
- 63: connection port
- 63A: box contact path
- 63B: box contact path
- 63C: box contact path
- 63D: box contact path
- 64: connection port
- 65: connection port
- 66: connection port
- 67: lid contact device
- 68: sealing lip
- 70: strain-relief device
- 71: base part
- 71a: upper surface of the base part
- 71b: lower surface of the base part
- 72: clamping part
- 73: adhering coupling layer of the strain-relief device
- 100: electrical wiring system
- 105: the electrical current supply device
- 106: sleeve
- 107: system connection portion
- 108: appliance connection portions
- 110: aircraft
- 111: outer skin
- 111A: area
- 120: fuselage structure
- 121: rib
- d1: first distance
- d2: second distance
- D: conductor depth direction
- H1: electrical conductor device semi-finished product
- I: interior of the box
- L: conductor longitudinal direction
- W: conductor width direction

## Claims

1. Electrical conductor device semi-finished product (H1) comprising:
a flexible printed circuit (10), FPC, comprising a first carrier layer (11) of a flexible dielectric material and extending in a conductor longitudinal direction (L), and at least one first conductor path (12; 13; 14; 15) of electrically conductive material arranged on a first surface (11a) of the first carrier layer (11) and extending along the conductor longitudinal direction (L), wherein the at least one conductor path (12; 13; 14; 15) comprises a plurality of first connection spots (12A; 13A; 14A; 15A) and a plurality second connection spots (12B; 13B; 14B; 15B), wherein the first and second connecting spots (12A; 13A; 14A; 15A; 12B; 13B; 14B; 15B) are arranged adjacent to each other with respect to the longitudinal direction (L), wherein adjacent first and second connecting spots (12A; 13A; 14A; 15A; 12B; 13B; 14B; 15B) which are arranged at a first distance (d1) to each other define a cut-off line (16) between each other which extends cross to the conductor longitudinal direction (L), wherein first and second connecting spots (12A; 13A; 14A; 15A; 12B; 13B; 14B; 15B) which are arranged adjacent each other in a second distance (d2) being greater than the first distance (d1) define a functional portion (17) between each other, and a casing layer (30) of a flexible dielectric plastic material embedding the FPC (10),
the electrical conductor device semi-finished product (H1) being **characterized in that**
the FPC (10) comprises at least one second conductor path (22; 23; 24; 25) of electrically conductive material arranged on a second surface (11b) of the first carrier layer (11) and extending in the conductor longitudinal direction (L), wherein the second surface (11b) of the first carrier layer (11) is oriented opposite to the first surface (11a), the at least one second conductor path (22; 23; 24; 25) comprising first connection spots and second connection spots being arranged adjacent to each other with respect to the longitudinal direction (L) and defining a cut-off line (16) between each other.

2. Electrical conductor device semi-finished product (H1) comprising:
a flexible printed circuit (10), FPC, comprising a first carrier layer (11) of a flexible dielectric material and extending in a conductor longitudinal direction (L), and at least one first conductor path (12; 13; 14; 15) of electrically conductive material arranged on a first surface (11a) of the first carrier layer (11) and extending along the conductor longitudinal direction (L), wherein the at least one conductor path (12; 13; 14; 15) comprises a plurality of first connection spots (12A; 13A; 14A; 15A) and a plurality second connection spots (12B; 13B; 14B; 15B), wherein the first and second connecting spots (12A; 13A; 14A; 15A; 12B; 13B; 14B; 15B) are arranged adjacent to each other with respect to the longitudinal direction (L), wherein adjacent first and second connecting spots (12A; 13A; 14A; 15A; 12B; 13B; 14B; 15B) which are arranged at a first distance (d1) to each other define a cut-off line (16) between each other which extends cross to the conductor longitudinal direction (L), wherein first and second connecting spots (12A; 13A; 14A; 15A; 12B; 13B; 14B; 15B) which are arranged adjacent each other in a second distance (d2) being greater than the first distance (d1) define a functional portion (17) between each other; and
a casing layer (30) of a flexible dielectric plastic material embedding the FPC (10);
the electrical conductor device semi-finished product (H1) being **characterized in that** the FPC (10) comprises at least two first conductor paths (12; 13; 14; 15) and further comprises a second carrier layer (21) of a flexible dielectric material embedded within the casing layer (30), wherein in a twist longitudinal section (19) of the FPC (10) a first section (12C) of a first conductor path (12) of the at least two first conductor paths (12; 13; 14; 15) extends on the first carrier layer (11) from a first cross-interconnecting spot (35A) to a second cross-interconnecting spot (35B) and from there a second section (12D) of the first conductor path (12) extends on the second carrier layer (21), and a first section (14C) of a second conductor path (14) of the at least two first conductor paths (12; 13; 14; 15) extends on the second carrier layer (21) from a third cross-interconnecting spot (35C) to a fourth cross-interconnecting spot (35D) and from there a second section (14D) of the second conductor path (14) extends on the first carrier layer (11), wherein the first and the fourth cross-interconnecting spots (35A; 35D) are arranged distanced to each other in the conductor longitudinal direction (L) and the second and third cross-interconnecting spots (35B; 35C) are arranged distanced to each other in the conductor longitudinal direction (L) and distanced to the first and the fourth cross-interconnecting spots (35A; 35D) in a direction cross to the conductor longitudinal direction (L), wherein the cross-interconnecting spots (35) are formed of an electrically conductive material and extend between the first and the second carrier layer (11; 21).

3. Electrical conductor device semi-finished product (H1)according to one of the claims 1 and 2, wherein the first and second connection spots (12A; 13A; 14A; 15A; 12B; 13B; 14B; 15B) are formed by accumulations of the electrically conductive material forming the at least one first and second conductor path (12; 13; 14; 15; 22; 23; 24; 25).

4. Electrical conductor device semi-finished product (H1)according to one of the preceding claims, wherein the first distance (d1) measures between 0,1 cm and 5 cm and the second distance (d2) measures between greater than 5 cm and smaller or equal 200 cm.

5. Electrical conductor device semi-finished product (H1) according to one of the preceding claims, further comprising:
a shielding (40) including a first and second shielding layer (41; 42) each having a plurality of thin electrically conductive wires (43; 44), wherein the first and second shielding layers (41; 42) are disposed on opposite sides of the first carrier layer (11).

6. Electrical conductor device semi-finished product (H1)according to one of the preceding claims, further comprising:
an adhering coupling layer (31) being disposed on a first surface (30a) of the casing layer (30).

7. Electrical wiring system (100) comprising:
an electrical conductor device (1) being formed from an electrical conductor device semi-finished product (H1) according to one of the preceding claims which is cut to a specific length at spaced cut-off lines (16);
a connection box (50) comprising a housing (51) which defines an interior of the box (50) and a lid (52);
an electrical connection device (60) being arranged in the interior of the box (50) and comprising electrical contact units (61);
wherein the first connection spots (12A; 13A; 14A; 15A) of the electrical conductor device (1) are electrically connected to the electrical contact units (61), and wherein an end portion (2) of the electrical conductor device (1) is clamped between the lid (52) and the housing (51) of the connection box (50).

8. Electrical wiring system (100) according to claim 7, further comprising:
at least one further electrical conductor device semi-fished product (H1) according to one of the claims 1 to 6 which is cut to a specific length at spaced cut-off lines (16), wherein the first connection spots (12A; 13A; 14A; 15A) of the at least one further electrical conductor device semi-finished product (H1) are electrically connected to the electrical contact units (61), and wherein an end portion (2) of the electrical conductor device semi-finished product (H1) is clamped between the lid (52) and the housing (51) of the connection box (50).

9. Electrical wiring system (100) according to one of the claims 7 and 8, further comprising:
a strain-relief device (70) including a base part (71) and a clamping part (72), wherein a section of the electrical conductor device (1) is clamped between the base part (71) and the clamping part (72) of the strain-relief device (70).

10. Electrical wiring system (100) according to claim 9, wherein the strain-relief device (70) further comprises an adhering coupling layer (73) being disposed on the base part (71).

11. Method for providing an electrical conductor device (1), comprising:
providing an electrical conductor device semi-finished product (H1) according to one of the claims 1 to 6; and
cutting-off of the electrical conductor device (1) along one of the cut-off lines (16) from the electrical conductor device semi-finished product.

12. Aircraft (110) comprising an electrical conductor device semi-finished product (H1) according to one of the claims 1 to 6.

## Patentansprüche

1. Elektrisches Leitervorrichtungshalbzeug (H1), umfassend:
eine flexible gedruckte Schaltung (10), FPC, umfassend eine erste Trägerschicht (11), die aus einem flexiblen dielektrischen Material ist und sich in einer Leiterlängsrichtung (L) erstreckt, und mindestens eine erste Leiterbahn (12; 13; 14; 15) aus elektrisch leitendem Material, die auf einer ersten Fläche (11a) der ersten Trägerschicht (11) angeordnet ist und sich entlang der Leiterlängsrichtung (L) erstreckt, wobei die mindestens eine Leiterbahn (12; 13; 14; 15) eine Mehrzahl von ersten Verbindungspunkten (12A; 13A; 14A; 15A) und eine Mehrzahl von zweiten Verbindungspunkten (12B; 13B; 14B; 15B) umfasst, wobei die ersten und zweiten Verbindungspunkte (12A; 13A; 14A; 15A; 12B; 13B; 14B; 15B) in Bezug auf die Längsrichtung (L) angrenzend aneinander angeordnet sind, wobei angrenzende erste und zweite Verbindungspunkte (12A; 13A; 14A; 15A; 12B; 13B; 14B; 15B), die in einem ersten Abstand (d1) zueinander angeordnet sind, eine Abschneidelinie (16) zwischen einander definieren, die sich quer zu der Leiterlängsrichtung (L) erstreckt, wobei erste und zweite Verbindungspunkte (12A; 13A; 14A; 15A; 12B; 13B; 14B; 15B), die angrenzend aneinander in einem zweiten Abstand (d2) angeordnet sind, der größer als der erste Abstand (d1) ist, einen Funktionsabschnitt (17) zwischen einander definieren, und eine Ummantelungsschicht (30) aus einem flexiblen dielektrischen Kunststoffmaterial, die die FPC (10) einbettet, wobei das elektrische Leitervorrichtungshalbzeug (H1) **dadurch gekennzeichnet ist, dass** die FPC (10) mindestens eine zweite Leiterbahn (22; 23; 24; 25) aus elektrisch leitendem Material umfasst, die an einer zweiten Fläche (11b) der ersten Trägerschicht (11) angeordnet ist und sich in der Leiterlängsrichtung (L) erstreckt, wobei die zweite Fläche (11b) der ersten Trägerschicht (11) entgegengesetzt zu der ersten Fläche (11a) ausgerichtet ist, wobei die mindestens eine zweite Leiterbahn (22; 23; 24; 25) erste Verbindungspunkte und zweite Verbindungspunkte umfasst, die in Bezug auf die Längsrichtung (L) angrenzend aneinander angeordnet sind und eine Abschneidelinie (16) zwischen einander definieren.

2. Elektrisches Leitervorrichtungshalbzeug (H1), umfassend:
eine flexible gedruckte Schaltung (10), FPC, umfassend eine erste Trägerschicht (11), die aus einem flexiblen dielektrischen Material ist und sich in einer Leiterlängsrichtung (L) erstreckt, und mindestens eine erste Leiterbahn (12; 13; 14; 15) aus elektrisch leitendem Material, die auf einer ersten Fläche (11a) der ersten Trägerschicht (11) angeordnet ist und sich entlang der Leiterlängsrichtung (L) erstreckt, wobei die mindestens eine Leiterbahn (12; 13; 14; 15) eine Mehrzahl von ersten Verbindungspunkten (12A; 13A; 14A; 15A) und eine Mehrzahl von zweiten Verbindungspunkten (12B; 13B; 14B; 15B) umfasst, wobei die ersten und zweiten Verbindungspunkte (12A; 13A; 14A; 15A; 12B; 13B; 14B; 15B) in Bezug auf die Längsrichtung (L) angrenzend aneinander angeordnet sind, wobei angrenzende erste und zweite Verbindungspunkte (12A; 13A; 14A; 15A; 12B; 13B; 14B; 15B), die in einem ersten Abstand (d1) zueinander angeordnet sind, eine Abschneidelinie (16) zwischen einander definieren, die sich quer zu der Leiterlängsrichtung (L) erstreckt, wobei erste und zweite Verbindungspunkte (12A; 13A; 14A; 15A; 12B; 13B; 14B; 15B), die angrenzend aneinander in einem zweiten Abstand (d2) angeordnet sind, der größer als der erste Abstand (d1) ist, einen Funktionsabschnitt (17) zwischen einander definieren; und eine Ummantelungsschicht (30) aus einem flexiblen dielektrischen Kunststoffmaterial, die die FPC (10) einbettet; wobei das elektrische Leitervorrichtungshalbzeug (H1) **dadurch gekennzeichnet ist, dass** die FPC (10) mindestens zwei erste Leiterbahnen (12; 13; 14; 15) umfasst und ferner eine zweite Trägerschicht (21) aus einem flexiblen dielektrischen Material umfasst, das in die Ummantelungsschicht (30) eingebettet ist, wobei sich in einem Verwindungslängsabschnitt (19) der FPC (10) ein erster Abschnitt (12C) einer ersten Leiterbahn (12) der mindestens zwei ersten Leiterbahnen (12; 13; 14; 15) auf der ersten Trägerschicht (11) von einem ersten Querverbindungspunkt (35A) zu einem zweiten Querverbindungspunkt (35B) erstreckt und sich von dort ein zweiter Abschnitt (12D) der ersten Leiterbahn (12) auf der zweiten Trägerschicht (21) erstreckt und sich ein erster Abschnitt (14C) einer zweiten Leiterbahn (14) der mindestens zwei ersten Leiterbahnen (12; 13; 14; 15) auf der zweiten Trägerschicht (21) von einem dritten Querverbindungspunkt (35C) zu einem vierten Querverbindungspunkt (35D) erstreckt und sich von dort ein zweiter Abschnitt (14D) der zweiten Leiterbahn (14) auf der ersten Trägerschicht (11) erstreckt, wobei die ersten und die vierten Querverbindungspunkte (35A; 35D) in der Leiterlängsrichtung (L) voneinander beabstandet angeordnet sind und die zweiten und dritten Querverbindungspunkte (35B; 35C) in der Leiterlängsrichtung (L) voneinander beabstandet und von den ersten und den vierten Querverbindungspunkten (35A; 35D) in einer Richtung quer zu der Leiterlängsrichtung (L) beabstandet angeordnet sind, wobei die Querverbindungspunkte (35) aus einem elektrisch leitenden Material ausgebildet sind und sich zwischen der ersten und der zweiten Trägerschicht (11; 21) erstrecken.

3. Elektrisches Leitervorrichtungshalbzeug (H1) nach einem der Ansprüche 1 und 2, wobei die ersten und zweiten Verbindungspunkte (12A; 13A; 14A; 15A; 12B; 13B; 14B; 15B) durch Ansammlungen des elektrisch leitenden Materials ausgebildet sind, das die mindestens eine ersten und zweite Leiterbahn (12; 13; 14; 15; 22; 23; 24; 25) ausbildet.

4. Elektrisches Leitervorrichtungshalbzeug (H1) nach einem der vorhergehenden Ansprüche, wobei der erste Abstand (d1) zwischen 0,1 cm und 5 cm misst und der zweite Abstand (d2) zwischen größer als 5 cm und kleiner als oder gleich 200 cm misst.

5. Elektrisches Leitervorrichtungshalbzeug (H1) nach einem der vorhergehenden Ansprüche, ferner umfassend:
eine Abschirmung (40), die eine erste und zweite Abschirmungsschicht (41; 42) umfasst, die jeweils eine Mehrzahl von dünnen elektrisch leitenden Drähten (43; 44) aufweisen, wobei die ersten und zweiten Abschirmungsschichten (41; 42) an entgegengesetzten Seiten der ersten Trägerschicht (11) angeordnet sind.

6. Elektrisches Leitervorrichtungshalbzeug (H1) nach einem der vorhergehenden Ansprüche, ferner umfassend:
eine haftende Kopplungsschicht (31), die auf einer ersten Fläche (30a) der Ummantelungsschicht (30) angeordnet ist.

7. Elektrisches Verkabelungssystem (100), umfassend:
eine elektrische Leitervorrichtung (1), die aus einem elektrischen Leitervorrichtungshalbzeug (H1) nach einem der vorhergehenden Ansprüche ausgebildet ist, das an beabstandeten Abschneidelinien (16) auf eine spezifische Länge geschnitten wird;
einen Verbindungskasten (50), umfassend ein Gehäuse (51), das einen Innenraum des Kastens (50) definiert, und einen Deckel (52);
eine elektrische Verbindungsvorrichtung (60), die in dem Innenraum des Kastens (50) angeordnet ist und elektrische Kontakteinheiten (61) umfasst;
wobei die ersten Verbindungspunkte (12A; 13A; 14A; 15A) der elektrischen Leitervorrichtung (1) mit den elektrischen Kontakteinheiten (61) elektrisch verbunden sind, und wobei ein Endabschnitt (2) der elektrischen Leitervorrichtung (1) zwischen den Deckel (52) und das Gehäuse (51) des Verbindungskastens (50) geklemmt ist.

8. Elektrisches Verkabelungssystem (100) nach Anspruch 7, ferner umfassend:
mindestens ein weiteres elektrisches Leitervorrichtungshalbzeug (H1) nach einem der Ansprüche 1 bis 6, das an beabstandeten Abschneidelinien (16) auf eine spezifische Länge geschnitten wird, wobei die ersten Verbindungspunkte (12A; 13A; 14A; 15A) des mindestens einen weiteren elektrischen Leitervorrichtungshalbzeugs (H1) mit den elektrischen Kontakteinheiten (61) elektrisch verbunden sind, und wobei ein Endabschnitt (2) des elektrischen Leitervorrichtungshalbzeugs (H1) zwischen den Deckel (52) und das Gehäuse (51) des Verbindungskastens (50) geklemmt ist.

9. Elektrisches Verkabelungssystem (100) nach einem der Ansprüche 7 und 8, ferner umfassend:
eine Zugentlastungsvorrichtung (70) mit einem Basisteil (71) und einem Klemmteil (72), wobei ein Abschnitt der elektrischen Leitervorrichtung (1) zwischen den Basisteil (71) und den Klemmteil (72) der Zugentlastungsvorrichtung (70) geklemmt ist.

10. Elektrisches Verkabelungssystem (100) nach Anspruch 9, wobei die Zugentlastungsvorrichtung (70) ferner eine haftende Kopplungsschicht (73) umfasst, die an dem Basisteil (71) angeordnet ist.

11. Verfahren zum Bereitstellen einer elektrischen Leitervorrichtung (1), umfassend:
Bereitstellen eines elektrischen Leitervorrichtungshalbzeugs (H1) nach einem der Ansprüche 1 bis 6; und
Abschneiden der elektrischen Leitervorrichtung (1) entlang einer der Abschneidelinien (16) von dem elektrischen Leitervorrichtungshalbzeug.

12. Luftfahrzeug (110), das ein elektrisches Leitervorrichtungshalbzeug (H1) nach einem der Ansprüche 1 bis 6 umfasst.

## Revendications

1. Produit semi-fini de dispositif conducteur électrique (H1) comprenant :
un circuit imprimé souple (10), FPC, comprenant une première couche de support (11) d'un matériau diélectrique flexible et s'étendant dans une direction longitudinale conductrice (L), et au moins une première piste conductrice (12 ; 13 ; 14 ; 15) de matériau électriquement conducteur agencé sur une première surface (11a) de la première couche de support (11) et s'étendant le long de la direction longitudinale conductrice (L), l'au moins une piste conductrice (12 ; 13 ; 14 ; 15) comprenant une pluralité de premiers points de connexion (12A ; 13A ; 14A ; 15A) et une pluralité de deuxièmes points de connexion (12B ; 13B ; 14B ; 15B), les premiers et deuxièmes points connecteurs (12A ; 13A ; 14A ; 15A ; 12B ; 13B ; 14B ; 15B) étant agencés adjacents les uns aux autres par rapport à la direction longitudinale (L), les premiers et deuxièmes points connecteurs adjacents (12A ; 13A ; 14A ; 15A ; 12B ; 13B ; 14B ; 15B) qui sont agencés à une première distance (d1) les uns des autres définissant une ligne de coupure (16) entre eux qui s'étend transversalement à la direction longitudinale conductrice (L), les premiers et deuxièmes points connecteurs (12A ; 13A ; 14A ; 15A ; 12B ; 13B ; 14B ; 15B) qui sont agencés adjacents les uns aux autres à une deuxième distance (d2) plus grande que la première distance (d1) définissant une partie fonctionnelle (17) entre eux, et une couche enveloppe (30) d'un matériau plastique diélectrique souple intégrant le FPC (10), le produit semi-fini de dispositif conducteur électrique (H1) étant **caractérisé en ce que** le FPC (10) comprend au moins une deuxième piste conductrice (22 ; 23 ; 24 ; 25) de matériau électriquement conducteur agencé sur une deuxième surface (11b) de la première couche de support (11) et s'étendant dans la direction longitudinale conductrice (L), la deuxième surface (11b) de la première couche de support (11) étant orientée à l'opposé de la première surface (11a), l'au moins une deuxième piste conductrice (22 ; 23 ; 24 ; 25) comprenant des premiers points de connexion et des deuxièmes points de connexion étant agencés adjacents les uns aux autres par rapport à la direction longitudinale (L) et définissant une ligne de coupure (16) entre eux.

2. Produit semi-fini de dispositif conducteur électrique (H1) comprenant :
un circuit imprimé souple (10), FPC, comprenant une première couche de support (11) d'un matériau diélectrique flexible et s'étendant dans une direction longitudinale conductrice (L), et au moins une première piste conductrice (12 ; 13 ; 14 ; 15) de matériau électriquement conducteur agencé sur une première surface (11a) de la première couche de support (11) et s'étendant le long de la direction longitudinale conductrice (L), l'au moins une piste conductrice (12 ; 13 ; 14 ; 15) comprenant une pluralité de premiers points de connexion (12A ; 13A ; 14A ; 15A) et une pluralité de deuxièmes points de connexion (12B ; 13B ; 14B ; 15B), les premiers et deuxièmes points connecteurs (12A ; 13A ; 14A ; 15A ; 12B ; 13B ; 14B ; 15B) étant agencés adjacents les uns aux autres par rapport à la direction longitudinale (L), les premiers et deuxièmes points connecteurs adjacents (12A ; 13A ; 14A ; 15A ; 12B ; 13B ; 14B ; 15B) qui sont agencés à une première distance (d1) les uns des autres définissant une ligne de coupure (16) entre eux qui s'étend transversalement à la direction longitudinale conductrice (L), les premiers et deuxièmes points connecteurs (12A; 13A; 14A; 15A; 12B; 13B; 14B; 15B) qui sont agencés adjacents les uns aux autres à une deuxième distance (d2) plus grande que la première distance (d1) définissant une partie fonctionnelle (17) entre eux ; et
une couche enveloppe (30) d'un matériau plastique diélectrique souple intégrant le FPC (10) ;
le produit semi-fini de dispositif conducteur électrique (H1) étant **caractérisé en ce que** le FPC (10) comprend au moins deux premières pistes conductrices (12 ; 13 ; 14 ; 15) et comprend en outre une deuxième couche de support (21) d'un matériau diélectrique souple intégré à l'intérieur de la couche enveloppe (30), dans lequel dans une section longitudinale de torsion (19) du FPC (10) une première section (12C) d'une première piste conductrice (12) des au moins deux premières pistes conductrices (12 ; 13 ; 14 ; 15) s'étend sur la première couche de support (11) d'un premier point d'interconnexion transversale (35A) à un deuxième point d'interconnexion transversale (35B) et à partir de là une deuxième section (12D) de la première piste conductrice (12) s'étend sur la deuxième couche de support (21), et une première section (14C) d'une deuxième piste conductrice (14) des au moins deux premières pistes conductrices (12; 13; 14; 15) s'étend sur la deuxième couche de support (21) d'un troisième point d'interconnexion transversale (35C) à un quatrième point d'interconnexion transversale (35D) et de là une deuxième section (14D) de la deuxième piste conductrice (14) s'étend sur la première couche de support (11), le premier et le quatrième point d'interconnexion transversale (35A; 35D) étant disposés à distance l'un de l'autre dans la direction longitudinale conductrice (L) et les deuxième et troisième points d'interconnexion transversale (35B ; 35C) étant agencés à distance l'un de l'autre dans la direction longitudinale conductrice (L) et à distance du premier et du quatrième point d'interconnexion transversale (35A; 35D) dans une direction transversale à la direction longitudinale conductrice (L), les points d'interconnexion transversale (35) étant formés d'un matériau électriquement conducteur et s'étendant entre la première et la deuxième couche de support (11 ; 21).

3. Produit semi-fini de dispositif conducteur électrique (Hl) selon l'une des revendications 1 et 2, dans lequel les premiers et deuxièmes points de connexion (12A; 13A; 14A; 15A; 12B; 13B; 14B; 15B) sont formés par accumulations du matériau électriquement conducteur formant l'au moins une première et deuxième piste conductrice (12 ; 13 ; 14 ; 15 ; 22 ; 23 ; 24 ; 25).

4. Produit semi-fini de dispositif conducteur électrique (Hl) selon l'une des revendications précédentes, dans lequel la première distance (d1) mesure entre 0,1 cm et 5 cm et la deuxième distance (d2) mesure entre plus de 5 cm et 200 cm ou moins.

5. Produit semi-fini de dispositif conducteur électrique (H1) selon l'une des revendications précédentes, comprenant en outre :
un blindage (40) incluant une première et une deuxième couche de blindage (41; 42) ayant chacune une pluralité de fils électriquement conducteurs fins (43 ; 44), les première et deuxième couches de blindage (41 ; 42) étant disposées sur des côtés opposés de la première couche de support (11).

6. Produit semi-fini de dispositif conducteur électrique (H1) selon l'une des revendications précédentes, comprenant en outre :
une couche de couplage adhésive (31) disposée sur une première surface (30a) de la couche enveloppe (30).

7. Système de câblage électrique (100) comprenant :
un dispositif conducteur électrique (1) étant formé à partir d'un produit semi-fini de dispositif conducteur électrique (H1) selon l'une des revendications précédentes qui est coupé à une longueur spécifique au niveau de lignes de coupure espacées (16) ;
un boîtier de connexion (50) comprenant un logement (51) qui définit un intérieur du boîtier (50) et un couvercle (52) ;
un dispositif de connexion électrique (60) étant agencé dans l'intérieur du boîtier (50) et comprenant des unités de contact électrique (61) ;
les premiers points de connexion (12A; 13A; 14A; 15A) du dispositif conducteur électrique (1) étant électriquement connectés aux unités de contact électrique (61), et une portion d'extrémité (2) du dispositif conducteur électrique (1) étant serrée entre le couvercle (52) et le logement (51) du boîtier de connexion (50).

8. Système de câblage électrique (100) selon la revendication 7, comprenant en outre : au moins un produit semi-fini de dispositif conducteur électrique (H1) supplémentaire selon l'une des revendications 1 à 6 qui est coupé à une longueur spécifique au niveau de lignes de coupure espacées (16), les premiers points de connexion (12A ; 13A ; 14A ; 15A) de l'au moins un produit semi-fini de dispositif conducteur électrique (H1) supplémentaire étant électriquement connectés aux unités de contact électrique (61), et une portion d'extrémité (2) du produit semi-fini de dispositif conducteur électrique (H1) étant serrée entre le couvercle (52) et le logement (51) du boîtier de connexion (50).

9. Système de câblage électrique (100) selon l'une des revendications 7 et 8, comprenant en outre :
un dispositif de soulagement de contrainte (70) incluant une portion de base (71) et une portion de serrage (72), une section du dispositif de conducteur électrique (1) étant serrée entre la portion de base (71) et la portion de serrage (72) du dispositif de soulagement de contrainte (70).

10. Système de câblage électrique (100) selon la revendication 9, dans lequel le dispositif de soulagement de contrainte (70) comprend en outre une couche de couplage adhésive (73) qui est disposée sur la portion de base (71).

11. Procédé pour fournir un dispositif conducteur électrique (1), comprenant :
la fourniture d'un produit semi-fini de dispositif conducteur électrique (H1) selon l'une des revendications 1 à 6 ; et
la découpe du dispositif conducteur électrique (1) le long de l'une des lignes de coupure (16) à partir du produit semi-fini de dispositif conducteur électrique.

12. Aéronef (110) comprenant un produit semi-fini de dispositif conducteur électrique (H1) selon l'une des revendications 1 à 6.
